Europäisches Patentamt

European Patent Office

Office européen des brevets

(11) Veröffentlichungsnummer: **0 281 743 B1**

(12) **EUROPÄISCHE PATENTSCHRIFT**

(45) Veröffentlichungstag der Patentschrift: **30.03.94**

(51) Int. Cl.5: **H01J 37/28**, H01J 37/12, H01J 37/14

(21) Anmeldenummer: **88100968.2**

(22) Anmeldetag: **22.01.88**

(54) **Detektorobjectiv für Rastermikroskope.**

(30) Priorität: **02.02.87 DE 3703029**

(43) Veröffentlichungstag der Anmeldung:
**14.09.88 Patentblatt 88/37**

(45) Bekanntmachung des Hinweises auf die
Patenterteilung:
**30.03.94 Patentblatt 94/13**

(84) Benannte Vertragsstaaten:
**DE FR GB IT NL**

(56) Entgegenhaltungen:
**DE-A- 3 236 273**

(73) Patentinhaber: **ICT Integrated Circuit Testing
Gesellschaft für Halbleiterprüftechnik mbH
Klausnerring 1a
D-85551 Kirchheim(DE)**

(72) Erfinder: **Rose, Harald, Prof.Dr.
Prinz-Christians-Weg 5 1/2
D-6100 Darmstadt(DE)**
Erfinder: **Zach, Joachim, Dipl.-Phys.
Bessunger Strasse 122
D-6100 Darmstadt(DE)**

(74) Vertreter: **Tetzner, Volkmar, Dr.-Ing. Dr. jur.
Van-Gogh-Strasse 3
D-81479 München (DE)**

**Beschreibung**

Die Erfindung betrifft ein Detektorobjektiv für Rastermikroskope nach dem Oberbegriff des Patentanspruchs 1 und ein Rastermikroskop nach dem Oberbegriff des Anspruchs 11.

Die elektrischen Eigenschaften moderner integrierter mikro- und optoelektronischer Bauelemente wird wesentlich von den geometrischen Abmessungen ihrer Teilsysteme beeinflußt. Die Einhaltung enger Maßtoleranzen ist deshalb insbesondere dann eine unverzichtbare Voraussetzung für die Herstellung funktionsfähiger Bauelemente mit gleichbleibenden physikalisch-elektrischen Eigenschaften, wenn sich die geometrischen Abmessungen der mit Hilfe moderner Lithografieverfahren erzeugten Strukturen im Mikrometer- und Submikrometerbereich bewegen.

In allen Bereichen der Entwicklung und Fertigung integrierter mikro- und optoelektronischer Bauelemente besteht deshalb ein steigender Bedarf an hochauflösenden abbildenden Systemen, die eine prozeßnahe Inspektion der erzeugten Strukturen und deren exakte Vermessung ermöglichen. Als für diese Zwecke besonders geeignet haben sich Rasterelektronenmikroskope herausgestellt, mit denen man Mikro- und Submikrometerstrukturen visuell beurteilen, Fehler und Abweichungen von Sollmustern feststellen und topographische Daten wie Längen, Breiten, Höhen oder Neigungswinkel erfassen und auswerten kann. Bei allen Untersuchungen der Bauelemente im Rasterelektronenmikroskop ist hierbei sicherzustellen, daß Veränderungen des Substrats, wie sie beispielsweise durch Kontaminationen oder Strahlenschäden auftreten können, vermieden werden.

Konventionelle Rasterelektronenmikroskope erreichen eine Auflösung von wenigen Nanometern nur bei hohen Beschleunigungsspannungen oberhalb etwa 20 kV, wo Resiststrukturen und Schaltungen durch die hochenergetischen Elektronen geschädigt und nicht- oder schlechtleitende Oberflächenbereiche der untersuchten Proben aufgeladen werden. Die in der Rasterelektronenmikroskopie übliche Metallisierung der Probe zur Unterdrückung der die Auflösung und die Abbildungsgüte beeinträchtigenden Aufladungen ist für die Untersuchung mikro- und optoelektronischer Bauelemente nicht geeignet, da deren Funktion durch eine aufgebrachte Metallschicht gestört oder in unzulässiger Weise verändert würde.

Der Erfindung liegt die Aufgabe zugrunde ein Detektorobjektiv der eingangs genannten Art anzugeben, mit dem die Auflösung und die Detektoreffizienz eines Rastermikroskopes, insbesondere eines Rasterelektronenmikroskopes bei niedrigen Primärenergien deutlich gesteigert werden kann. Diese Aufgabe wird erfindungsgemäß durch ein Detektorobjektiv nach Patentanspruch 1 und durch ein Rastermikroskop nach Anspruch 11 gelöst.

Der mit der Erfindung erzielbare Vorteil besteht insbesondere darin, daß Teilchensonden mit kleinem Querschnitt auch bei niedrigen Primärenergien erzeugt werden können. Außerdem sind hochauflösende und nahezu aufladungsfreie Untersuchungen nicht- oder schlechtleitender Proben gewährleistet.

Die Ansprüche 2 bis 10 und 12-16 sind auf bevorzugte Ausgestaltungen und Weiterbildungen der Erfindung gerichtet, die nachfolgend anhand der Zeichnungen näher erläutert wird.

Hierbei zeigt

FIG 1 den schematischen Aufbau eines Rasterelektronenmikroskopes mit einem erfindungsgemäßen Detektorobjektiv,

FIG 2 ein Achtpolelement des Linsensystems zur Korrektur der sphärischen und chromatischen Aberrationen des Detektorobjektivs,

FIG 3 a und 3 b ein erfindungsgemäßes Detektorobjektiv mit integriertem Ablenkelement.

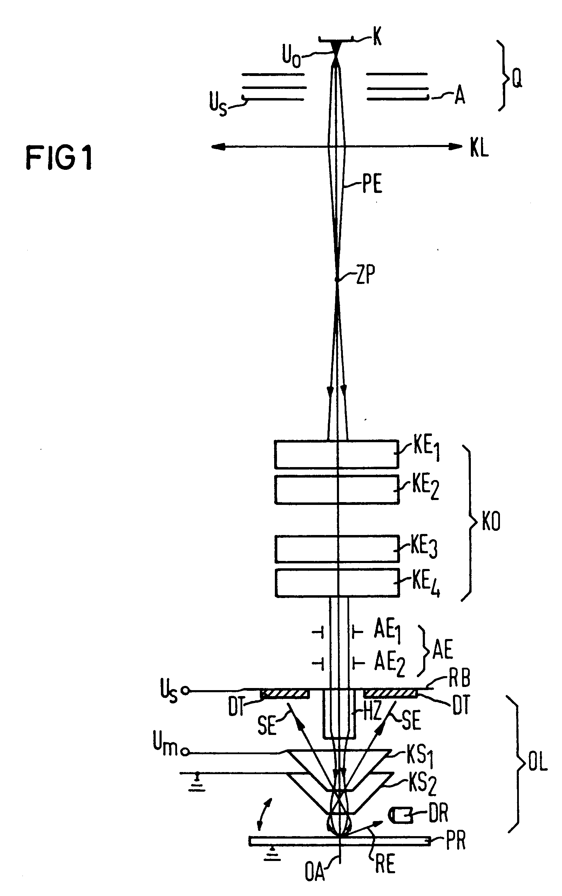

Das in FIG 1 schematisch dargestellte Rasterelektronenmikroskop besteht im wesentlichen aus einem Elektronenstrahlerzeuger, vorzugsweise einer Feldemissionsquelle Q, einer Kondensorlinse KL zur Fokussierung der von der Kathode K emittierten und in Richtung der Anode A beschleunigten Primärelektronen PE in ein auf der Strahlachse OA liegendes Zwischenbild ZP der Elektronenquelle, einem Linsensystem (Korrektor) mit mindestens vier Acht- oder Zwölfpolelementen $KE_1$ bis $KE_4$ zur Korrektur der sphärischen und chromatischen Aberrationen der abbildenden Linse, einem im Strahlengang unmittelbar hinter dem Korrektor KO angeordneten zweistufigen Ablenkelement AE mit jeweils zwei über nicht dargestellte Signalgeneratoren angesteuerten zylinder- oder plattenförmigen Strukturen $AE_1$ und $AE_2$ und einer elektrostatischen Objektivlinse OL zur verkleinerten Abbildung des Zwischenbildes ZP der Quelle auf die unmittelbar unterhalb der Objektivlinse OL auf einer Halterung angeordneten Probe PR. Als Objektivlinse OL ist eine Immersionslinse mit Mittelektrode $KS_1$ vorgesehen, deren auf dem Andenpotential $U_s$ liegende quellenseitige Elektode eine ringförmige Blende RB mit einem konznetrisch zur Strahlachse OA angeordneten und sich in Richtung der Probe PR erstreckenden Hohlzylinder HZ aufweist. Die als Steuerelektrode wirkende, mit einem variablen positiven Potential $U_m$ ($U_m > U_s$) beaufschlagte Mittelelektrode $KS_1$ und die auf dem Potential der Probe PR liegende probenseitige Elektode $KS_2$ der Immersionslinse OL sind kegelstumpfförmig ausgebildet und konzentrisch zur Strahlachse OA angeordnet. Um die Probe PR auch in geneigtem Zustand untersuchen und abbilden zu können, schließen die Seitenflächen der sich in Richtung der Probe PR verjüngenden Elektroden $KS_1$ bzw. $KS_2$ vorzugsweise einen Winkel $\alpha$ zwischen etwa 30 und 70 Grad mit der Strahlachse OA ein.

Der Detektor DT zum Nachweis der auf der Probe PR von den Primärelektronen PE ausgelösten Sekundärelektronen SE ist in dem gezeigten Ausführungsbeispiel innerhalb der Immersionslinse OL zwischen der quellenseitigen und der mittleren Elektrode RB/HZ bzw. $KS_1$ konzentrisch zur Strahlachse OA angeordnet. Er besteht vorzugsweise aus einem ringförmigen elektronensensitiven Teil, der in der Zentralbohrung des Hohlzylinders HZ der quellenseitigen Elektrode der Immersionslinse OL isoliert gehaltert ist. Zur Erzielung verschiedener Kontraste ist es zweckmäßig, den Detektor DT in mehrere Segmente zu unterteilen und die in diesen Segmenten erzeugten Signale in der gewünschten Weise zu kombinieren (z. B. Differenzbildung der in zwei Halbringdetektoren erzeugten Signale oder Unterdrückung eines der Signale). Da der Hohlzylinder HZ auf einem etwas niedrigeren positiven Potential $U_s$ als die Mittelelektrode $KS_1$ der Immersionslinse OL liegt ($U_m > U_s$), werden insbesondere die unter kleinen Winkeln zur Strahlachse OA laufenden Sekundärelektronen SE in Richtung des Detektors DT abgelenkt und nachgewiesen. Der Hohlzylinder HZ dient außerdem der Abschirmung des primären Elektronenstrahls von der am Detektor DT anliegenden Hochspannung von beispielsweise + 10 kV zur Nachbeschleunigung der Sekundärelektronen SE. Als Detektoren DT kommen insbesondere die beispielsweise aus der Veröffentlichung von W. K. Hofkar, Philips Technische Rundschau Nr. 12, 1966, Seite 323 bis 337 bekannten Halbleiterdetektoren in Betracht, deren teilchensensitive Bereiche gegebenenfalls segmentiert aufgebaut und als Metall-Halbleiter- oder p - n - Übergang ausgebildet sind. Selbstverständlich kann man auch Szintillator-Lichtleiterkombinationen oder Channel-Plates als Sekundärelektronendetektoren verwenden. Ringförmige Detektoren besitzen gegenüber anderen Detektorkonfigurationen allerdings den Vorteil, daß man nahezu alle der im rotationssymmetrischen elektrischen Feld der Immersionslinse OL von der Probe PR abgesaugten Sekundärelektronen SE erfassen und nachweisen kann.

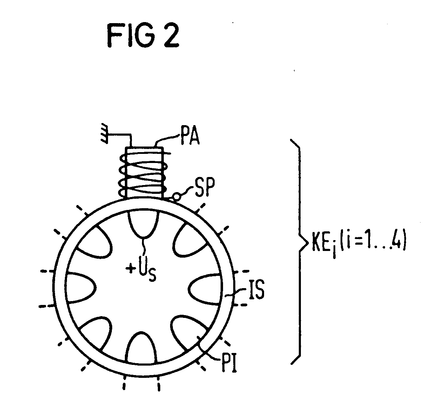

Das als Korrektor bezeichnete und aus mindestens 4 Acht- oder Zwölfpolelementen $KE_1$ bis $KE_4$ bestehende Linsensystem KO ist aus den Veröffentlichungen von H. Rose "Elektronenoptische Aplanate", Optik 34, Heft 3, 1971 Seite 285 bis 311 (siehe insbesondere Seite 308 FIG 9) und H. Koops "Aberration Correction in Electron Microscopy " 9th International Congress on Electron Microscopy, Toronto 1978, Vol 3, Seite 185 bis 196 (siehe insbesondere Seite 191, FIG 4) bekannt. Dieses im Strahlengang unmittelbar oberhalb des zweistufigen Ablenkelementes AE angeordnete Linsensystem KO dient der Korrektur der Öffnungs- und Farbfehler des Detektorobjektivs OL. Eines der Achtpolelemente $KE_i$ (i = 1...4) des Korrektors KO ist schematisch in FIG 2 dargestellt. Es besteht aus acht auf dem Anodenpotential $U_s$ liegendeninneren Polschuhen PI, die durch einen zylinderförmigen Isolator IS von den auf Erdpotential liegenden und mit jeweils einer Erregerspule SP umgebenen äußeren Polschuhen PA getrennt sind. Mit jedem dieser Elemente $KE_i$ werden magnetische Quadrupol- und Oktupolfelder zur Korrektur der Öffnungsfehler des Detektorobjektivs OL erzeugt. Zur Korrektur ihres Farbfehlers werden elektrische Quadrupolfelder verwendet, die man mit Hilfe eines an den Innenelektroden PI anliegenden Zusatzpotentials in den mittleren Elementen $KE_2$ und $KE_3$ des Korrektors KO aufbaut.

Auf das quellenseitige Ablenkelement $AE_1$ kann verzichtet werden, wenn man innerhalb des probenseitigen Korrektorelementes $KE_4$ zusätzlich noch elektrische Dipolfelder zur Vorablenkung des Primärelektronenstrahles PE erzeugt.

Vier Acht- oder Zwölfpolelemente $KE_1$ bis $KE_4$ reichen zur Korrektur der Öffnungs- und Farbfehler des Detektorobjektivs OL aus. Die Verwendung von fünf Elementen bietet allerdings zusätzlich die Möglichkeit, auch außeraxiale Fehler der Objektivlinse zu korrigieren. Diese Abbildungsfehler sind in einem Rasterelektronenmikroskop mit einem zweistufigen Ablenkelement AE allerdings vernachlässigbar klein, so daß man auf ein fünftes Korrektorelement i. A. verzichten kann. Da die Öffnungsfehler dritter Ordnung mit den Achtpolelementen $KE_1$ bis $KE_4$ korrigierbar sind, begrenzen die mit dem Abstand zwischen dem Korrektor KO und dem Detektorobjektiv OL anwachsenden Öffnungsfehler fünfter Ordnung die Auflösung. Deren Einfluß kann man durch Verwendung zwölfpoliger Elemente im Korrektor KO erheblich reduzieren, ohne die Korrekturen niedrigerer Ordnung zu beeinträchtigen.

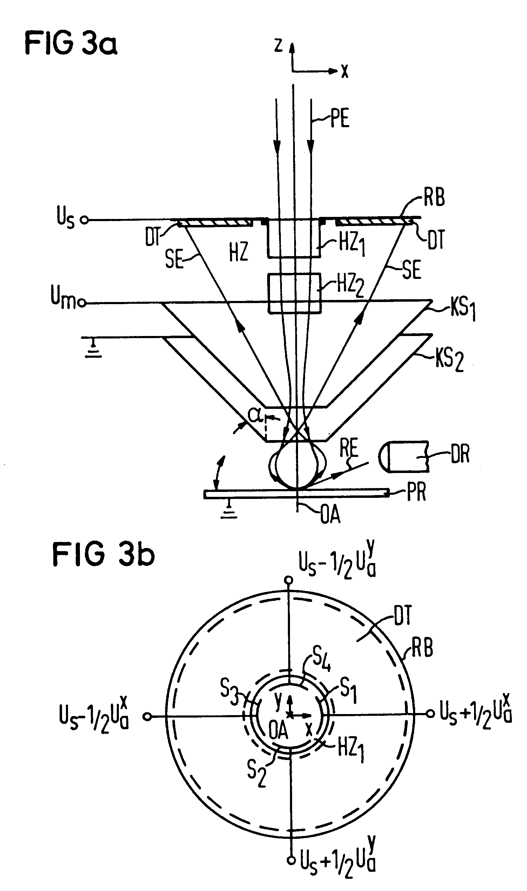

Zur weiteren Reduktion des mit dem Abstand zwischen dem Korrektor KO und der Immersionslinse OL anwachsenden Öffnungsfehler fünfter Ordnung wird das zweistufige Ablenkelement AE, wie in den FIG 3 a und 3 b schematisch dargestellt, erfindungsgemäß in die quellenseitige Elektrode des Detektorobjektivs OL integriert, indem man den Hohlzylinder HZ isoliert von der ringförmigen Blende RB anordnet, ihn in einer Ebene senkrecht zur Strahlachse OA teilt und den oberen und unteren Zylinderteil $HZ_1$ bzw. $HZ_2$ jeweils wieder in vier oder acht Sektoren S1 bis S4 untergliedert (siehe FIG 3 b). Diese auf dem Anodenpotential $U_s$ liegenden Segmente S1 bis S4 werden zur Positionierung des Primärelektronenstrahles PE auf der Probe PR bzw. zu dessen zeilenförmiger Ablenkung mit geeigneten Zusatzpotentialen $U^x_a$ bzw. $U^y_a$ -

EP 0 281 743 B1

(Ablenkung in x- bzw. y-Richtung) beaufschlagt. Ein weiterer Vorteil der Integration des Ablenkelementes in das Detektorobjektiv OL besteht darin, daß größere Ablenkwinkel eingestellt (kleinerer Abstand Ablenkelement - Linsenfeld) und damit größere Oberflächenbereiche der Probe PR abgetastet werden können. Da der Primärelektronenstrahl PE in zweistufigen Ablenkelementen für alle Ablenkwinkeln um den sogenannten komafreien Punkt der Objektivlinse OL gekippt wird, werden die bei einstufigen Ablenkelementen auftretenden außeraxialen Aberrationen (außeraxialer Linsendurchtritt des Strahls) vermieden.

Es ist bekannt, daß sich der Ladungszustand eines von einem Elektronenstrahl abgetasteten Oberflächenbereichs ändert, wenn die den Ladeprozeß bestimmende Größe s (s = Ausbeute emittierter Elektronen = mittlere Zahl der pro auftreffendem Primärelektron ausgelöste Sekundär- und Rückstreuelektronen) von eins abweicht. Aufladungsfreie Untersuchungen nicht- oder schlechtleitender Proben in einem Rasterelektronenmikroskop sind deshalb nur dann möglich, wenn die Energie $E_{PE}$ der Primärelektronen mit der vom Probenmaterial abhängigen Neutralpunktenergie $E_{NP}$ übereinstimmt ($E_{PE} \approx E_{NP} \Rightarrow s(E_{PE}) \approx 1$). Da die Neutralpunktenergie $E_{NP}$ mit wenigen Ausnahmen im Energiebereich zwischen etwa 0,5 und 4 keV liegt, müssen konventionelle Rasterelektronenmikroskope mit niedrigen Beschleunigungsspannungen betrieben werden. Unter solchen Betriebsbedingungen wird allerdings der kleinste auf der Probe erreichbare Sondendurchmesser im wesentlichen durch den der Fokussierung entgegenwirkenden Boersch-Effekt und den axialen Farbfehler der abbildenden Linse begrenzt. So wächst infolge der auf dem gesamten Strahlengang zwischen Quelle und Probe wirkenden Coulomb-Abstoßung zwischen den Elektronen deren räumlicher Abstand und damit der Sondendurchmesser (lateraler Boersch-Effekt). Außerdem führt die Wechselwirkung zwischen den Elektronen in Bereichen hoher Stromdichten, also insbesondere im Elektronenstrahlerzeuger Q und den Strahlüberkreuzungspunkten (z. B. ZP in FIG 1) zu einer Verbreiterung der Energieverteilung der Primärelektronen PE, was indirekt über den Farbfehler der Objektivlinse ebenfalls zu einer Vergrößerung des Sondendurchmessers führt. Für den die Auflösung bestimmten Sondendurchmesser d auf der Probe gilt hierbei die bekannte Beziehung

$$d = (d_0^2 + d_F^2)^{1/2}$$

wobei $d_o$ den um die Coulomb-Abstoßung der Elektronen zwischen Strahlerzeuger und Probe (Einfluß des lateralen Boersch-Effektes) erweiterten geometrisch-optischen Sondendurchmesser und $d_F$ den Durchmesser des durch den Farbfehler der abbildenden Linse erzeugten Farbfehlerscheibchens bezeichnet. Die Größe $d_F$ wiederum ist über die Beziehung

$$d_F = 2\, C_F \cdot \alpha \cdot \Delta U/U$$

definiert, wobei $C_F$ die Farbfehlerkonstante der abbildenden Linse, $\alpha$ die Strahlapertur, eU die Primärenergie (U = Beschleunigungsspannung, e = Elementarladung) und $e\Delta U$ die Breite der Energieverteilung der Elektronen bezeichnet. Eine weitere Verbesserung der Auflösung des Rasterelektronenmikroskops nach FIG 1 kann daher insbesondere durch eine Reduktion des lateralen und energetischen Boersch-Effektes im Strahlerzeuger und in der elektronenoptischen Säule erreicht werden.

Die erfindungsgemäßen Detektorobjektive werden vorteilhafterweise in Niederspannungs-Rasterelektronenmikroskopen eingesetzt, in denen der Boersch-Effekt die Auflösung bei niedrigen Teilchenenergien und hohen Strahlströmen begrenzt. Da der Einfluß des lateralen Boersch-Effektes mit wachsender kinetischer Energie eU abnimmt (Verkürzung der Laufzeit der Elektronen zwischen Quelle und Probe), die Breite der Energieverteilung $e\Delta U$ der Primärelektronen infolge des energetischen Boersch-Effektes aber deutlich zunimmt, sollten die Elektronen den ersten Strahlüberkreuzungspunkt (Quellen-crossover) mit niedriger Energie durchlaufen (kleine relative Energiebreite $e\Delta U/eU$), um sie anschließend auf hohe Energien zu beschleunigen und erst kurz vor dem Erreichen der Probe auf die gewünschte niedrige Endenergie abzubremsen. Um den nachteiligen Einfluß des Boersch-Effektes auf den Sondendurchmesser in einem Rasterelektronenmikroskop nach FIG 1 für Elektronenendenergien von 0,2 - 5 keV zu minimieren, können die Elektroden des Strahlerzeugers K, A und des Detektorobjektivs OL beispielsweise mit folgenden Potentialen beaufschlagt werden:

4

```
Elektronenstrahlerzeuger Q

Kathode K                                    U  = - 0,2 bis - 5 kV
                                              O
Anode A                                      U  = + 10 bis + 30 kV
                                              S


Detektorobjektiv OL

quellenseitige Elektrode                     U   = U   = U
HZ/RB                                         HZ    RB    S

Mittelelektrode KS                           U   = 1,1 U  bis 2,5 U
                  1                            KS1      S           S
probenseitige Elektrode KS                   U    = OV
                           2                  KS2


Probe PR                                     U    = OV
                                              PR
```

Die Erfindung ist selbstverständlich nicht auf die in den Figuren dargestellten Ausführungsbeispiele beschränkt. So ist es keineswegs notwendig, die Elektrode $KS_2$ des Detektorobjektivs OL und die Probe PR auf das gleiche Potential zu legen. Die Primärelektronen können selbstverständlich auch erst außerhalb des Strahlerzeugers Q auf hohe kinetische Energien beschleunigt werden. In diesem Fall liegt die quellenseitige Elektrode RB, HZ des Detektorobjektivs vorzugsweise auf dem Potential der die Primärelektronen beschleunigenden Elektrodenanordnung.

Zum Nachweis der Rückstreuelektronen RE kann das Detektorobjektiv noch mit einem zweiten Detektor DR ausgestattet sein, den man, wie in FIG 1 dargestellt, beispielsweise seitlich oberhalb der Probe PR anordnet. Er kann aber auch anstelle des Sekundärelektronendetektors innerhalb des Detektorobjektivs angeordnet werden.

Als Primär- und Sekundärteilchen kommen selbstverständlich beispielsweise auch Ionen und andere geladene Teilchen in Betracht.

**Patentansprüche**

1. Detektorobjektiv für Rastermikroskope, gekennzeichnet dadurch, daß
   - das Detektorobjektiv als eine Immersionslinse (OL) ausgebildet ist mit einer quellenseitigen Elektrode (RB, HZ), einer probenseitigen Elektrode ($KS_2$) und einer Mittelelektrode ($KS_1$) und
   - ein Detektorsystem (DT) zum Nachweis der von einem primären Teilchenstrahl (PE) auf einer Probe (PR) ausgelösten sekundären oder rückgestreuten Teilchen (SE, RE) innerhalb der Immersionslinse konzentrisch zur Strahlachse (OA) des Rastermikroskopes angeordnet ist.

2. Detektorobjektiv nach Anspruch 1, dadurch **gekennzeichnet,** daß die quellenseitige Elektrode (RB, HZ) der Immersionslinse (OL) auf einem ersten positiven Potential ($U_s$) liegt und daß die Mittelelektrode ($KS_1$) der Immersionslinse (OL) mit einem höheren zweiten positiven Potential ($U_m$) beaufschlagt ist.

3. Detektorobjektiv nach Anspruch 1 oder 2, dadurch **gekennzeichnet,** daß die quellenseitige Elektrode (HZ, RB) der Immersionslinse (OL) auf dem Potential ($U_s$) einer teilchenbeschleunigenden Elektrode (A) des Rastermikroskops liegt.

4. Detektorobjektiv nach einem der Ansprüche 1 bis 3, dadurch **gekennzeichnet,** daß die probenseitige Elektrode ($KS_2$) der Immersionslinse (OL) und die Probe (PR) auf dem gleichen Potential liegen.

5. Detektorobjektiv nach einem der Ansprüche 1 bis 4, dadurch **gekennzeichnet,** daß die Mittelelektrode ($KS_1$) und die probenseitige Elektrode ($KS_2$) jeweils kegelstumpfförmig ausgebildet sind.

6. Detektorobjektiv nach einem der Ansprüche 5, dadurch **gekennzeichnet,** daß der Kegelmantel der Mittelelektrode ($KS_1$) und der probenseitigen Elektrode ($KS_2$) der Immersionslinse (OS) jeweils einen Winkel ($\alpha$) zwischen 30 und 70 Grad mit der Strahlachse (OL) des Rastermikroskopes einschließt.

**7.** Detektorobjektiv nach einem der Ansprüche 1 bis 6, dadurch **gekennzeichnet,** daß die quellenseitige Elektrode (HZ, RB) der Immersionslinse (OL) einen konzentrisch zur Strahlachse (OA) angeordneten ringförmigen Teil (RB) und einen in dessen Zentralbohrung angeordneten, sich in Strahlrichtung erstreckenden Hohlzylinder (HZ) aufweist.

**8.** Detektorobjektiv nach einem der Ansprüche 1 bis 7, dadurch **gekennzeichnet,** daß das Detektorsystem (DT) ringförmig ausgebildet und zwischen der quellenseitigen Elektrode (HZ, RB) und der Mittelelektrode (KS$_1$) angeordnet ist.

**9.** Detektorobjektiv nach einem der Ansprüche 1 bis 8, dadurch **gekennzeichnet,** daß ein Ablenkelement (AE) zur Positionierung des primären Teilchenstrahls (PE) in die quellenseitige Elektrode (HZ, RB) der Immersionslinse (OL) integriert ist.

**10.** Detektorobjektiv nach Anspruch 7, dadurch **gekennzeichnet,** daß der Hohlzylinder (HZ) der quellenseitigen Elektrode (HZ, RB) der Immersionslinse (OL) isoliert angeordnet und in einer Ebene senkrecht zur Strahlachse (OA) unterteilt ist und daß der obere und der untere Teil des Hohlzylinders (HZ$_1$, HZ$_2$) jeweils aus vier oder acht Segmenten (S$_1$ bis S$_4$) besteht.

**11.** Rastermikroskop mit einem Strahlerzeuger (Q), einem ersten Linsensystem (KL) zur Bündelung eines Teilchenstrahls (PE), einem zweiten Linsensystem (OL) zur Fokussierung eines Teilchenstrahls (PE) auf eine Probe (PR), einer Ablenkeinheit (AE) und einem Detektorsystem (DT) zum Nachweis der auf der Probe (PR) ausgelösten sekundären oder rückgesteuerten Teilchen (SE), dadurch gekennzeichnet, daß das zweite Linsensystem eine Immersionslinse (OL) mit einer quellenseitigen Elektrode (RB, HZ), einer probenseitigen Elektrode (KS$_2$) und einer Mittelektrode (KS$_1$) als Objektivlinse aufweist, daß das Detektorsystem (DT) innerhalb der Immersionslinse (OL) angeordnet ist und daß ein aus mindestens (vier) Acht- oder Zwölfpol-Elementen (K1) bis (K4) bestehendes drittes Linsensystem (KO) im Strahlengang zwischen dem ersten Linsensystem (KL) und der Immersionslinse (OL) angeordnet ist.

**12.** Rastermikroskop nach Anspruch 11, dadurch **gekennzeichnet,** daß das dritte Linsensystem (KO) aus fünf Acht- oder Zwölfpolelementen besteht.

**13.** Rastermikroskop nach Anspruch 11 oder 12, dadurch **gekennzeichnet,** daß die Ablenkeinheit (AE) im Strahlengang zwischen dem zweiten (OL) und dem dritten Linsensystem (KO) angeordnet ist.

**14.** Rastermikroskop nach einem der Ansprüche 11 bis 13, dadurch **gekennzeichnet,** daß die Ablenkeinheit (AE) in eine quellenseitige Elektrode (RB, HZ) der Immersionslinse (OL) integriert ist.

**15.** Rastermikroskop nach einem der Ansprüche 11 bis 14, dadurch **gekennzeichnet,** daß die quellenseitige Elektrode (RB, HZ) der Immersionslinse (OL) auf dem Potential (U$_s$) einer teilchenbeschleunigenden Elektrode (A) des Rastermikroskops liegt.

**16.** Rastermikroskop nach einem der Ansprüche 11 bis 15, dadurch **gekennzeichnet,** daß das erste Linsensystem (KL) mindestens eine magnetische Linse aufweist.

**Claims**

**1.** Detector objective for scanning microscopes, characterised in that
- the detector objective is constructed as an immersion lens (OL) with a source-side electrode (RB, HZ), a specimen-side electrode (KS$_2$) and a middle electrode (KS$_1$) and
- a detector system (DT) for documenting the secondary or backscatter particles (SE, RE) triggered by a primary particle beam (PE) on a specimen (PR) is arranged within the immersion lens concentrically with the beam axis (OA) of the scanning microscope.

**2.** Detector objective as claimed in Claim 1, characterised in that the source-side electrode (RB, HZ) of the immersion lens (OL) lies at a first positive potential (U$_s$) and that a higher second positive potential (U$_m$) is applied to the middle electrode (KS$_1$) of the immersion lens (OL).

3. Detector objective as claimed in Claim 1 or 2, characterised in that the source-side electrode (HZ, RB) of the immersion lens (OL) lies at the potential ($U_s$) of a particle-accelerating electrode (A) of the scanning microscope.

4. Detector objecting as claimed in one of Claims 1 to 3, characterised in that the specimen-side electrode ($KS_2$) of the immersion lens (OL) and the specimen (PR) are at the same potential.

5. Detector objective as claimed in one of Claims 1 to 4, characterised in that the middle electrode ($KS_1$) and the specimen-side electrode ($KS_2$) are each constructed in the form of a truncated cone.

6. Detector objective as claimed in Claim 5, characterised in that the conical surface of the middle electrode ($KS_1$) and of the specimen-side electrode ($KS_2$) of the in each case encloses an angle ($\alpha$) between 30° and 70° with the beam axis (OL) of the scanning microscope.

7. Detector objective as claimed in one of Claims 1 to 6, characterised in that the source-side electrode (HZ, RB) of the immersion lens (OL) has an annular part arranged concentrically with the beam axis (OA) and a hollow cylinder (HZ) arranged in the central bore thereof and extending in the beam direction.

8. Detector objective as claimed in one of Claims 1 to 7, characterised in that the detector system (DT) is of annular construction and is arranged between the source-side electrode (HZ, RB) and the middle electrode ($KS_1$).

9. Detector objective as claimed in one of Claims 1 to 8, characterised in that a deflecting element (AE) for positioning the primary particle beam (PE) is integrated into the source-side electrode (HZ, RB) of the immersion lens (OL).

10. Detector objective as claimed in Claim 7, characterised in that the hollow cylinder (HZ) of the source-side electrode (HZ, RB) of the immersion lens is arranged insulated and is divided in a plane perpendicular to the beam axis (OA) and the the upper and the lower part of the hollow cylinder ($HZ_1$, $HZ_2$) consists in each case of four or eight segments ($S_1$ to $S_4$).

11. Scanning microscope with a beam generator (Q), a first lens system (KL) for concentrating a particle beam (PE), a second lens system (OL) for focussing a particle beam (PE) onto a specimen (PR), a deflecting unit (AE) and a detector system (DT) for documenting the secondary or backscatter particles (SE) triggered on the specimen (PR), characterised in that the second lens system has an immersion lens (OL) with a source-side electrode (RB, HZ), a specimen-side electrode ($KS_2$) and a middle electrode ($KS_1$) as objective lens, that the detector system is arranged within the immersion lens (OL) and that a third lens system (KO) consisting of at least four eight-pole or twelve-pole elements (K1 to K4) is arranged in the beam path between the first lens system (KL) and the immersion lens (OL).

12. Scanning microscope as claimed in Claim 11, characterised in that the third lens system (KO) consists of five eight-pole or twelve-pole elements.

13. Scanning microscope as claimed in Claim 11 or 12, characterised in that the deflecting unit (AE) is arranged in the beam path between the second (OL) and the third lens system (KO).

14. Scanning microscope as claimed in one of Claims 11 to 13, characterised in that the deflecting unit (AE) is integrated into a source-side electrode (RB, HZ) of the immersion lens (OL).

15. Scanning microscope as claimed in one of Claims 11 to 14, characterised in that the source-side electrode (RB, HZ) of the immersion lens (OL) is at the potential ($U_s$) of a particle-accelerating electrode (A) of the scanning microscope.

16. Scanning microscope as claimed in one of Claims 11 to 15, characterised in that the first lens system (KL) has at least one magnetic lens.

**Revendications**

1. Objectif détecteur pour microscope à balayage, caractérisé en ce que l'objectif détecteur est constitué d'une lentille à immersion (OL) comprenant une électrode côté source (RB, HZ), une électrode côté échantillon (KS$_2$) et une électrode médiane (KS$_1$) et

un système détecteur (DT), destiné à déceler les particules secondaires ou rétrodiffusées (SE, RE) qui sont détachées sur un échantillon (PR) par un faisceau primaire de particules (PE), est disposé à l'intérieur de la lentille à immersion, concentriquement à l'axe (OA) du faisceau du microscope à balayage.

2. Objectif détecteur selon la revendication 1, caractérisé en ce que l'électrode côté source (RB, HZ) de la lentille à immersion (OL) est à un premier potentiel positif (U$_s$) et en ce que l'électrode médiane (KS$_1$) de la lentille à immersion (OL) reçoit un second potentiel positif supérieur (U$_m$).

3. Objectif détecteur selon la revendication 1 ou 2, caractérisé en ce que l'électrode côté source (HZ, RB) de la lentille à immersion (OL) est au potentiel (U$_s$) d'une électrode (A) d'accélération des particules du microscope à balayage.

4. Objectif détecteur selon l'une des revendications 1 à 3, caractérisé en ce que l'électrode côté échantillon (KS$_2$) de la lentille à immersion (OL) et l'échantillon (PR) sont au même potentiel.

5. Objectif détecteur selon l'une des revendications 1 à 4, caractérisé en ce que l'électrode médiane (KS$_1$) et l'électrode côté échantillon (KS$_2$) ont chacune la forme d'un tronc de cône.

6. Objectif détecteur selon la revendication 5, caractérisé en ce que l'enveloppe conique de l'électrode médiane (KS$_1$) et celle de l'électrode côté échantillon (KS$_2$) de la lentille à immersion (OS) inscrivent chacune un angle ($\alpha$) compris entre 30 et 70 degrés avec l'axe (OL) du faisceau du microscope à balayage.

7. Objectif détecteur selon l'une des revendications 1 à 6, caractérisé en ce que l'électrode côté source (HZ, RB) de la lentille à immersion (OL) comprend une partie annulaire (RB) disposée concentriquement à l'axe du faisceau (OA) et un cylindre creux (HZ) disposé dans le trou central de cette partie annulaire et orienté dans le sens du faisceau.

8. Objectif détecteur selon l'une des revendications 1 à 7, caractérisé en ce que le système détecteur (DT) est annulaire et disposé entre l'électrode côté source (HZ, RB) et l'électrode médiane (KS$_1$).

9. Objectif détecteur selon l'une des revendications 1 à 8, caractérisé en ce qu'un élément de déviation (AE) destiné à positionner le faisceau de particules primaires (PE) est intégré dans l'électrode côté source (HZ, RB) de la lentille à immersion (OL).

10. Objectif détecteur selon la revendication 7, caractérisé en ce que le cylindre creux (HZ) de l'électrode côté source (HZ, RB) de la lentille à immersion (OL) est monté de manière à être isolé et il est subdivisé dans un plan perpendiculaire à l'axe du faisceau (OA) et en ce que chacune des parties supérieure et inférieure du cylindre creux (HZ$_1$, HZ$_2$) se compose de quatre ou huit segments (S$_1$ à S$_4$).

11. Microscope à balayage comprenant un générateur de faisceau (Q), un premier système de lentilles (KL) destiné à concentrer un faisceau de particules (PE), un second système de lentilles (OL) destiné à focaliser un faisceau de particules (PE) sur un échantillon (PR), un groupe de déviation (AE) et un système détecteur (DT) destiné à déceler les particules secondaires détachées de l'échantillon (PR) ou les particules retrodiffusées (SE), caractérisé en ce que le second système de lentilles comprend une lentille à immersion (OL) comportant une électrode côté source (RB, HZ), une électrode côté échantillon (KS$_2$) et une électrode médiane (KS$_1$) constituant une lentille de l'objectif, en ce que le système détecteur (DT) est disposé à l'intérieur de la lentille à immersion (OL) et en ce qu'un troisième système de lentille (KO) se composant d'au moins quatre éléments à huit ou douze pôles (K1) à (K4) est disposé dans la marche du faisceau entre le premier système de lentille (KL) et la lentille à immersion (OL).

**12.** Microscope à balayage selon la revendication 11, caractérisé en ce que le troisième système de lentille (KO) se compose de cinq éléments à huit ou douze pôles.

**13.** Microscope à balayage selon la revendication 11 ou 12, caractérisé en ce que le groupe de déviation (AE) est disposé dans la marche du faisceau entre le second (OL) et le troisième système de lentilles (KO).

**14.** Microscope à balayage selon l'une des revendications 11 à 13, caractérisé en ce que le groupe de déviation (AE) est intégré dans une électrode côté source (RB, HZ) de la lentille à immersion (OL).

**15.** Microscope à balayage selon l'une des revendications 11 à 14, caractérisé en ce que l'électrode côté source (RB, HZ) de la lentille à immersion (OL) est au potentiel ($U_s$) d'une électrode (A) d'accélération de particules du microscope à balayage.

**16.** Microscope à balayage selon l'une des revendications 11 à 15, caractérisé en ce que le premier système de lentilles (KL) comprend au moins une lentille magnétique.

FIG 1

## FIG 2

## FIG 3a

## FIG 3b